# EUROPEAN PATENT SPECIFICATION

(11) **EP 0 682 223 B1**
(45) Date of publication and mention of the grant of the patent: **07.01.1999**
(21) Application number: 94929011.8
(22) Date of filing: 06.10.1994
(51) Int. Cl.: F28F 3/12, F28D 15/02, H01L 21/48, H01L 23/427

(54) **HEAT SINK WITH A HEAT PLATE**
WÄRMESENKE MIT WÄRMEABFÜHRUNGSPLATTE
PUITS DE CHALEUR POURVU D'UNE PLAQUE DE DISSIPATION DE CHALEUR

(30) Priority: 08.12.1993 JP 308090/93
(43) Date of publication of application: 15.11.1995
(73) Proprietor: FANUC LTD., Minamitsuru-gun, Yamanashi 401-05 (JP)
(72) Inventor: SHINOHARA, Tatsuo, Fanuc Mansion Harimomi 9-303, Yamanashi 401-05 (JP); TAKESHITA, Makoto, Fanuc-3 Villa Karamatsu, Yamanashi 401-05 (JP)
(74) Representative: Jackson, Peter Arthur
(86) International application number: JP9401674
(87) International publication number: WO9516177

(56) References cited:
- FR-A- 2 486 308
- JP-A- 2 110 296
- JP-A- 6 085 480
- JP-U- 1 157 491
- JP-U- 2 054 065
- JP-U-63 200 347
- IBM TECHNICAL DISCLOSURE BULLETIN, vol. 24, no. 2, July 1981, page 1222 XP002006408 PARSAPOUR: "Convection cooling in small terminals"
- Extract from a sales catalog, Showa Aluminum Co., Ltd. 1993

## Description

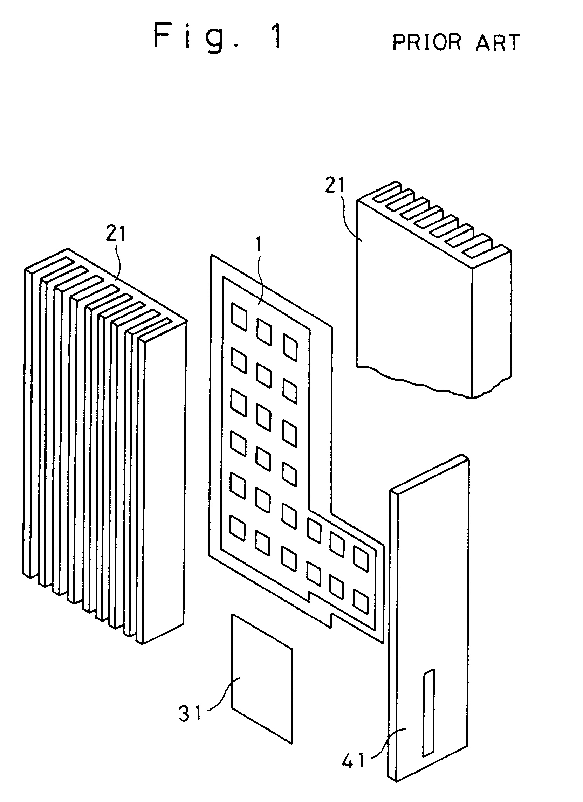

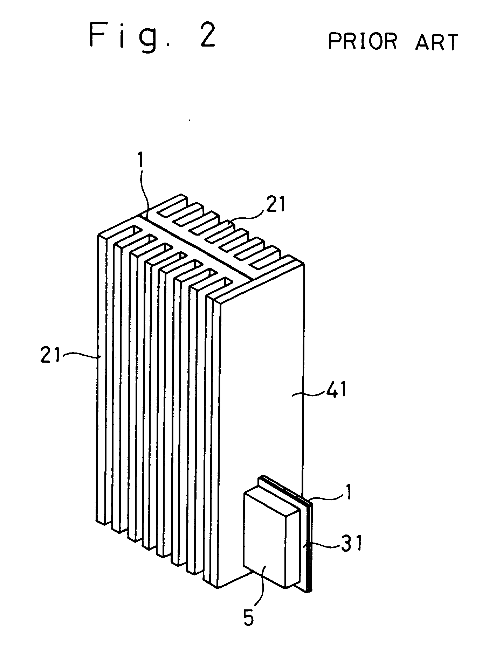

This invention relates to a heat sink comprising a heat plate comprising the features of the preamble of claim 1. Such a heat sink is shown in Figs. 1 and 2.

A heat sink comprising a heat plate is available in the prior art. A heat plate is defined as a small sized vertical type heat exchanger produced by sticking two aluminum plates with an adhesive, leaving a closed path for allowing a medium for heat exchange such as Freon or the like to flow therein. When employed, a heat plate is stood in the vertical position to allow the heat exchange medium such as Freon to circulate in the vertical direction within the closed path, for the purpose to allow heat exchange to occur between the gas of the heat exchange medium which is inclined to go upward and the liquid of the heat exchange medium which is inclined to go downward. In this manner, a heat plate is allowed to transmit heat from an object to be cooled which is attached to the bottom of the heat plate toward a cooling fin etc. which is attached to the top of the heat plate to radiate the heat therefrom.

Fig. 1 illustrates a broken perspective view of a heat sink attached by a heat plate available in the prior art, and Fig. 2 illustrates an assembled perspective view of a heat sink attached by a heat plate available in the prior art. Referring to Figs. 1 and 2, a heat sink attached by a heat plate available in the prior art consists of a heat plate 1, a cooling fin 21 produced by employing an aluminum extrusion process, a heat transmission plate 31 with which an object to be cooled 5 is attached to the heat plate 1 and of which the object is improvement of heat transmission efficiency between an object to be cooled 5 and the heat plate 1, and a flange 41 produced by employing an aluminum die casting process and which is employed to mount the heat sink on a cubicle etc. which is employed for mounting electrical equipment or the like. Since the surface of the heat plate 1 is not even due to the closed path for heat exchange medium produced between the two aluminum plates, employment of an aluminum soldering process is essential to stick a cooling fin 21 on the heat plate 1.

As was described above, the production of a heat sink attached by a heat plate available in the prior art requires a large number of parts and employment of an aluminum soldering process. Therefore, the heat sink attached by a heat plate available in the prior art is involved with a drawback in which the process for fabrication thereof is long and complicated, resulting in a high production cost.

The object of this invention is to provide a heat sink attached by a heat plate which requires small number of parts to be employed for fabrication thereof and a short and simple process for fabrication thereof and which does not require employment of an aluminum soldering process, resultantly causing a short and simple process for fabrication thereof and a less production cost.

According to the present invention, a heat sink comprises a heat plate which has been produced by sticking two aluminum plates to each other, leaving a closed path therebetween for allowing a heat exchange medium to be confined therein and to circulate therein in the vertical direction, and of which a lower surface part is attached to an object to be cooled, a cooling fin which is stuck to at least the upper region of one surface of the heat plate, and a flange connected to the cooling fin to be employed for mounting the assembly of the heat plate and the cooling fin, (as disclosed by Showa Aluminum Co. Ltd. in their sales literature of 1993) and is characterised in that the surface of the heat plate, on which the cooling fin is to be attached, is even and the cooling fin and the flange are fabricated in one body by employing a die casting process.

In the accompanying drawings:

Fig. 1 is a broken perspective view of a heat sink attached by a heat plate available in the prior art.

Fig. 2 is an assembled perspective view of a heat sink attached by a heat plate available in the prior art.

Fig. 3 is a cross-sectional view of a heat plate employed for a heat sink attached by a heat plate in accordance with one embodiment of this invention.

Fig. 4 is a perspective view of the assembly of a cooling fin and a flange employed for a heat sink attached by a heat plate in accordance with one embodiment of this invention, which assembly is fabricated by employing a die casting process.

Fig. 5 is a broken perspective view of a heat sink attached by a heat plate in accordance with one embodiment of this invention.

Fig. 6 is an assembled perspective view of a heat sink attached by a heat plate in accordance with one embodiment of this invention.

Referring to drawings, a heat sink comprising a heat plate in accordance with one embodiment of this invention will be described below.

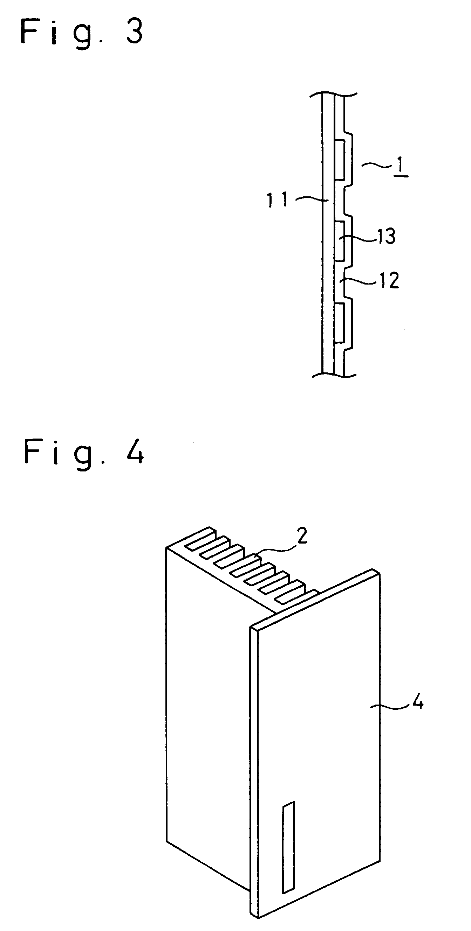

Referring to Fig. 3, a heat plate 1 consists of two aluminum plates 11 and 12, which are stuck to each other. The surface of the aluminum plate 11 on which surface a cooling fin 2 is scheduled to be stuck is made even and the surface of the other aluminum plate 12 is allowed to be uneven. A path for a heat exchange medium 13 is left between the two aluminum plates 11 and 12 at a location corresponding to the projection caused by the path for a heat exchange medium 13. The heat plate 1 having the foregoing cross-section can be readily produced by employng the steps described below. Two aluminum plates 11 and 12 are piled on a table having a flat surface. A fluid is forced with high pressure between the two aluminum plates 11 and 12 at the region at which a path for a heat exchange medium 13 is scheduled to be produced, while the surface of the aluminum plate 12 is being pressed with high pressure on the region at which a path for a heat exchange medium 13 is not scheduled to be produced. In this manner, a path for a heat exchange medium 13 is inflated with a fluid.

Referring to Fig. 4, a die casting process is conducted to fabricate the assembly of a cooling fin 2 and a flange 4. Since the assembly of the cooling fin 2 and the flange 4 are fabricated in one body, the number of the parts to be employed for production thereof is reduced.

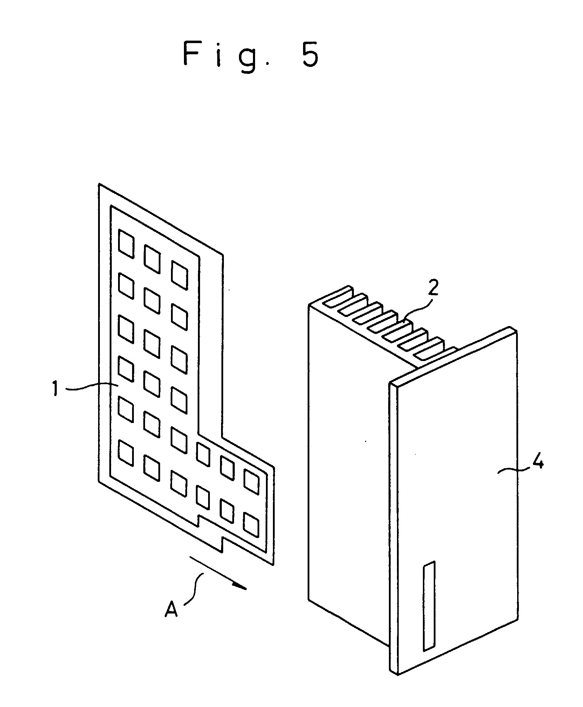

Referring to Fig. 5, the heat plate 1 is assembled into the assembly of a cooling fin 2 and a flange 4, as illustrated by an arrow A. Since one surface (the rear surface in the drawing) of the heat plate 1 is an even plane, the heat plate 1 can be stuck fast with screws, an adhesive or the like, without employing an aluminum soldering process.

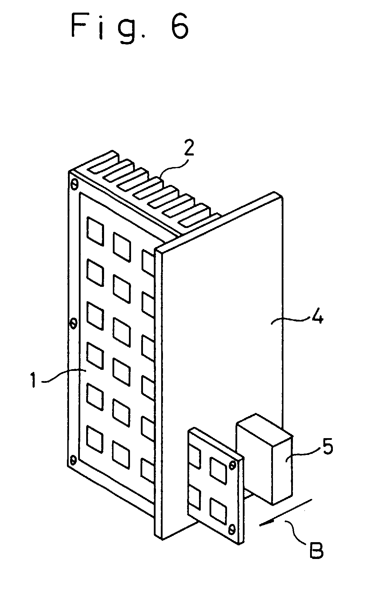

Referring to Fig. 6, an object to be cooled 5 can be fitted on one surface (the rear surface in the drawing) of the heat plate 1 with screws, an adhesive or the like, in the direction of an arrow B. Since the surface (the rear surface in the drawing) of the heat plate 1 on which surface the object to be cooled 5 is attached, is an even plane, the heat transmission plate 31 is unnecessary, though the heat transmission plate 31 is essential in the prior art. In this manner, the number of the parts to be employed for production thereof is reduced. Due to the same reason, employment of an aluminum soldering process is unnecessary to fit the object to be cooled 5 on the heat plate 1.

As was described above, the surface of the heat plate employed for a heat sink attached by a heat plate in accordance with this invention, on which surface a cooling fin 2 is stuck, is an even plane. Therefore, employment of an aluminum soldering process is unnecessary in the entire process for fabrication of the heat sink attached by a heat plate in accordance with this invention. A cooling fin 2 and a flange 4 are fabricated in one body by employing a die casting process. Therefore, the number of the parts to be employed for production thereof is reduced, and the assembly process is made short and simple. As a result, the production cost of the heat sink attached by a heat plate in accordance with this invention is considerably less than that of the prior art.

### INDUSTRIAL APPLICABILITY

As was described above, a heat sink attached by a heat plate in accordance with this invention requires a less number of parts to be employed for production thereof and a shorter and less complicated fabrication process and does not require an aluminum soldering process in the entire process for production thereof. Therefore, the heat plate in accordance with this invention is definitely useful for cooling articles to be cooled, such as semiconductor devices or the like which are usually mounted in cubicles or the like.

## Claims

1. A heat sink comprising a heat plate (1) which has been produced by sticking two aluminum plates (11 and 12) to each other, leaving a closed path (13) therebetween for allowing a heat exchange medium to be confined therein and to circulate therein in the vertical direction, and of which a lower surface part is attached to an object to be cooled (5), a cooling fin (2) which is stuck to at least the upper region of one surface of the heat plate (1), and a flange (4) connected to the cooling fin (2) to be employed for mounting the assembly of the heat plate (1) and the cooling fin (2), characterised in that the surface of the heat plate (1), on which the cooling fin (2) is to be attached, is even and the cooling fin (2) and the flange (4) are fabricated in one body by employing a die casting process.

2. A heat sink according to claim 1 characterised in that the object to be cooled (5) is also attached to the even surface of the heat plate (1).

## Patentansprüche

1. Wärmesenke, umfassend eine Wärmeplatte (1), die durch das Zusammenfügen zweiter Aluminiumplatten (11 und 12) unter Belassen eines geschlossenen Weges (13) zwischen ihnen, für das Einschließen und Zirkulieren eines Wärmeaustauschmediums in vertikaler Richtung hergestellt wurde, wobei ein unterer Oberflächenteil an einem zu kühlenden Objekt (5) befestigt ist, eine Kühlrippe (2), die an mindestens dem oberen Gebiet einer Oberfläche der Wärmeplatte (1) befestigt ist, und einen Flansch (4), der mit der Kühlrippe (2) verbunden ist, um die Vorrichtung aus der Wärmeplatte (1) und der Kühlrippe (2) zu montieren, dadurch gekennzeichnet, daß die Oberfläche der Wärmeplatte (1), an der die Kühlrippe (2) befestigt werden soll, eben ist, und die Kühlrippe (2) und der Flansch (4) in einem Körper unter Verwendung eines Druckgußverfahrens hergestellt werden.

2. Wärmesenke nach Anspruch 1, dadurch gekennzeichnet, daß das zu kühlende Objekt (5) auch an der ebenen Oberfläche der Wärmeplatte (1) befestigt wird.

## Revendications

1. Dissipateur thermique comprenant une plaque de dissipation (1) qui a été produite en collant l'une à l'autre deux plaques d'aluminium (11 et 12) , en laissant entre elles un passage clos (13) pour permettre à un milieu d'échange thermique d'y être confiné et d'y circuler dans la direction verticale, et dont une portion de surface inférieure est attachée à un objet (5) à refroidir, un élément (2) de refroidissement à ailettes qui est collé sur au moins la région supérieure d'une surface de la plaque de dissipation (1), et une semelle (4) reliée à l'élément (2) de refroidissement à ailettes pour être utilisée pour monter l'ensemble de la plaque de dissipation (1) et de l'élément (2) de refroidissement à ailettes, caractérisé en ce que la surface de la plaque de dissipation (1) à laquelle doit être attachée l'élément (2) de refroidissement à ailettes est plane, et l'élément (2) de refroidissement à ailettes et la semelle (4) sont fabriqués dans une seule pièce en employant un procédé de coulée sous pression.

2. Dissipateur thermique selon la revendication 1, caractérisé en ce que l'objet (5) à refroidir est également attaché à la surface plane de la plaque de dissipation (1).
